Europäisches Patentamt

European Patent Office

Office européen des brevets

(11) Publication number: **0 034 483**
**B2**

# NEW EUROPEAN PATENT SPECIFICATION

(45) Date of publication of the new patent specification:
02.11.88

(51) Int. Cl.⁴: **H 01 L 21/60,** H 01 L 21/00,
H 01 L 21/31

(21) Application number: 81300607.9

(22) Date of filing: 13.02.81

(54) Process for patterning a layer, for forming a contact through hole.

(30) Priority: 14.02.80 JP 16858/80

(43) Date of publication of application:
26.08.81 Bulletin 81/34

(45) Publication of the grant of the patent:
02.10.85 Bulletin 85/40

(45) Mention of the opposition decision:
02.11.88 Bulletin 88/44

(84) Designated Contracting States:
DE FR GB NL

(56) References cited:
EP-A-0 003 733
EP-A-0 030 116
DE-A-2 534 043
DE-A-2 554 638
DE-A-2 723 499
DE-A-2 723 933
DE-A-2 754 066
DE-A-2 804 830
DE-A-2 823 855
US-A-3 544 401
US-A-4 148 133

(73) Proprietor: FUJITSU LIMITED, 1015, Kamikodanaka
Nakahara- ku, Kawasaki- shi Kanagawa 211 (JP)

(72) Inventor: Nakajima, Makoto, 18- 13, Ohyama- cho
Shibuya- ku, Tokyo 151 (JP)

(74) Representative: Sunderland, James Harry,
HASELTINE LAKE & CO Hazlitt House 28
Southampton Buildings Chancery Lane, London
WC2A 1AT (GB)

EP 0 034 483 B2

## Description

The present invention relates to a process for forming a contact through hole in an insulating layer in particular of a semiconductor device such as for instance an integrated circuit (IC).

In the production of a semiconductor integrated circuit, a portion of an insulating layer, for example an insulating layer for protection (i.e. a passivation film), over a lower conductor layer, is selectively removed to make a through hole (i.e. a via hole) and then an upper conductor layer (i.e. a conductive pattern) is formed on the insulating layer so as to come into contact with the lower conductor layer (i.e. another conductive pattern) through the through hole. When this is done, it is possible for cracks to be generated in the upper conductor layer (e.g. of aluminium) at the edge of the insulating layer defining the through hole. As a result, disconnection between the upper and lower conductor layers may occur. In order to prevent such cracks from occurring, it is important to eliminate the (sharp) edge of the insulating layer and to shape the side surface of the through hole into a sloping configuration.

Various etching methods for forming a through hole having a sloping side surface have been proposed.

For example, a portion of an insulating layer on a conductor layer can be selectively removed through an opening in a patterned photoresist mask by using an etching solution to form the through hole.

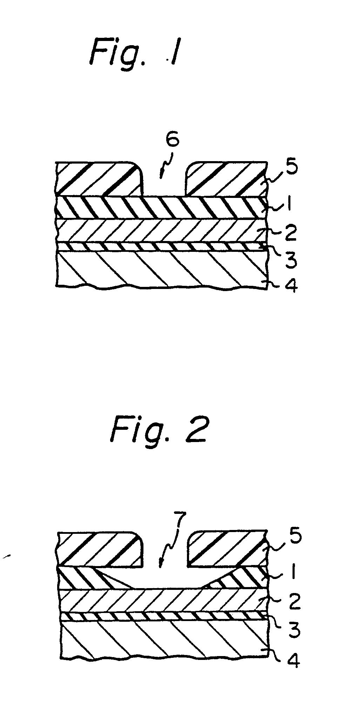

Such a wet-etching method is explained in detail with reference to Figures 1 and 2 of the accompanying drawings, which are respective partial schematic cross-sectional views.

An insulating layer (e.g. a phosphosilicate glass film) 1 is formed on a conductor layer (e.g. an aluminium pattern) 2 lying on another insulating layer (e.g. a silicon dioxide layer) 3 and a semiconductor substrate (e.g. a single crystalline silicon substrate) 4. A photoresist layer 5 is applied on the insulating layer 1 and is then exposed and developed to form a patterned mask having an opening 6 therein as illustrated in Figure 1. A portion of the insulating layer 1 (e.g. a phosphosilicate glass) is selectively etched by using a suitable etching solution (e.g. a mixed solution of hydrofluoric acid (HF) and nitric acid $(NHO_3)$) to form a through a hole 7, as illustrated in Figure 2.

The bottom of the through hole 7 is of a larger size, and the top of the through hole 7 is of a considerably larger size, than the size of the opening 5 in the photoresist layer 5, since the etching solution can remove the insulating layer 1 from under the edge of the photoresist layer 5 (that is, so-called undercutting or side etching occurs), and in practice overetching is carried out to ensure reliable formation of complete through holes in semiconductor device chips of a semiconductor substrate (wafer). With a through hole 7 so formed, it is possible to prevent the occurrence of cracks in an upper conductor layer;

however, the formed through hole is larger than the desired size, so that the density of the conductor pattern and the integration density of the integrated circuit for example are low.

Decreasing the amount of undercutting, a contact through hole can be formed by a combination of wet-etching and dry-etching, as described in prior European patent application EP-A-0 030 116, which belongs to the state of the art according to Art. 54(3) EPC.

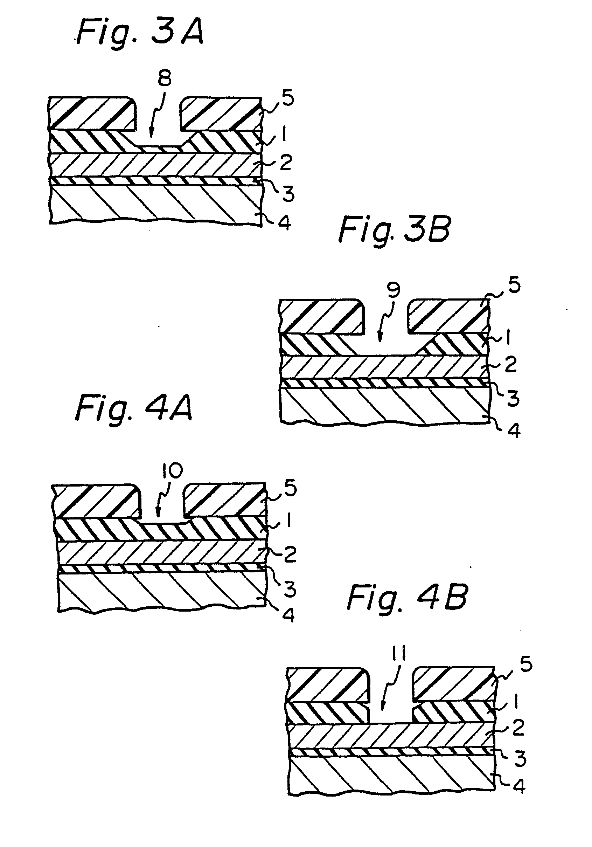

For example, an exposed portion of the insulating layer 1 (Figure 1) is wet-etched by the etching solution through the opening 6 in the photoresist layer 5. For instance, the insulating layer 1, having a thickness of 1.0 micron, is wet-etched to form a part or preceding hole 8 having a depth of 0.7 microns, with the result that a portion of the insulating layer having a thickness of 0.3 microns remains, as illustrated in Figure 3A of the accompanying drawings, which is a partial schematic cross-sectional view. Then, in a conventional dry-etching (e.g. reactive sputter etching, plasma etching) apparatus, the insulating layer 1 is further etched to complete a through hole 9, as illustrated in Figure 3B of the accompanying drawings, which is a partial schematic cross-sectional view. The bottom of the through hole 9 has a smaller size and the side of thet hrough hole slopes at a steeper angle as compared with the through hole 7 (Figure 2) formed by wet-etching only. In this case, since a space is formed between the bottom plane of the photoresist layer 5 and the slope (inclined plane) of the preceding hole 8 (Figure 3A) in the wet-etching, an etchant used for dry-etching can remove the insulating layer 1 from under the photoresist layer 5 to a slight degree, to induce a small undercut. Thus, the through hole 9 is slightly larger than the desired size.

In another case, the insulating layer 1 having a thickness of 1.0 micron is wet-etched to form a part or preceding hole 10 having a depth of 0.3 microns, as illustrated in Figure 4A of the accompanying drawings, which is a partial schematic cross-sectional view. Then, in the same dry-etching apparatus the insulating layer 1 is further etched to complete a through hole 11, as illustrated in Figure 4B of the accompanying drawings, which is a partial schematic cross-sectional view. The formed through hole 11 has an almost vertical side surface and a short slope formed by wet-etching. Since the through hole 11 does not have a slope extending over the whole depth of the hole, cracks may occur in a conductor layer (not shown) formed over the through hole at the edge of the through hole 11, when this conductor layer is formed by a conventional process on the insulating layer 1 and on the portion of the conductor layer 2 exposed in the through hole.

From DE-A-2 534 043 a process for forming a contact through hole in an insulating layer is known, comprising the steps of; forming a patterned photoresist layer on the insulating layer; dry etching part way through the insulating layer, using the photoresist layer as a mask to form a part or preceding hole; and wet-etching the insulating layer using the photoresist layer as a mask, to complete the through hole. From EP-A-0 003 733 a process for forming a through hole is known comprising the steps of: forming a patterned photoresist on an insulating layer; wet-etching completely through the insulating layer, using the photoresist layer as a mask, to form a hole; heating the photoresist layer to bend the end portion of the photoresist layer around the hole; and etching a layer of electrode material provided under said insulating layer using the photoresist layer as a mask.

According to the present invention a process for forming a contact through hole in an insulating layer disposed on a first conductor layer comprises the steps of forming on the insulating layer a patterned photoresist layer having an opening therein corresponding to the desired through hole; wet-etching part way through the insulating layer, using the photoresist layer as a mask, to form a part or preceding hole that has sloping sides and undercuts the end portion of the photoresist layer; heating the photoresist layer at a temperature under the softening point of the photoresist to bend the end portion of the photoresist layer around the part or preceding hole so that the said end portion does not come into contact with the slope of the part or preceding hole; and dry etching the insulating layer, using the photoresist layer as a mask, to complete the through hole with sloping sides.

An embodiment of the present invention can provide a process for forming a contact through hole having a slope such as to prevent cracks from occurring in a conductor layer to be formed on the slope.

An embodiment of the present invention can facilitate a density increase in an integrated in an circuit of a semiconductor device by providing for the formation of a contact through hole accurately to a desire side.

An embodiment of the present invention provides a process for forming a throughhole, for the establishment of a connection between an upper conductor layer and a lower conductor layer, in an insulating layer between the upper and lower conductor layers. Since heating bends the end portion of the photoresist layer to such an extent that the end portion does not come into contact with the side surface of the part or preceding hole, the final through hole with sloped side surface can be formed by dry-etching without any enlargement of the top plane size of the part or preceding hole.

Reference is made, by way of example, to the accompaning drawings, in which:

Figure 1 is a partial cross-sectional view of a semiconductor device prior to formation of a contact through hole;

Figure 2 is a partial cross-sectional view of a semiconductor device after formation of a contact through hole by wet-etching only;

Figures 3A and 3B are partial cross-sectional views of a semiconductor device respectively after formation of a part or preceding hole by wet-etching, after completion of through hole formation by dry-etching;

Figures 4A and 4B are partial cross-sectional views of a semiconductor device respectively after formation of a shallow part or preceding hole by wet-etching, and after completion of through hole formation by dry-etching (as described in said EP-A-0 030 116);

Figures 5A to 5D are partial cross-sectional views illustrating respective stages in the manufacture of a semiconductor device with multilayer conductors by a method embodying the present invantion; and

Figures 6A and 6B are partial cross-sectional views illustrating respective stages in the manufacture of a semiconductor device after formation of a shallow part or preceding hole and a bent end portion of a photoresist layer and after completion of formation of a through hole.

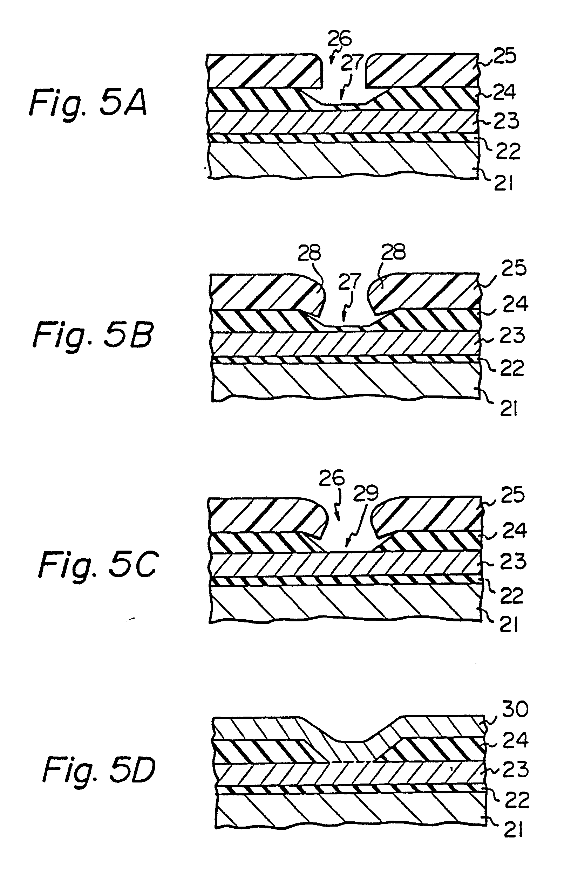

Referring now to Figures 5A to 5D, a process for forming a contact through hole in an insulating layer which lies between multilayer conductors of a semiconductor device will be explained in more detail.

On a semiconductor substrate (e.g. a single crystalline silicon substrate) 21 (Figure 5A) a first insulating layer (e.g. a silicon dioxide layer) 22 is formed by a suitable method (e.g. a thermal oxidation method). The semiconductor substrate has active elements and passive elements as integrated circuit elements. A first conductor layer 23 made of metal (e.g. aluminium) and having a desired pattern is formed on the first insulating layer 22 by a conventional process (e.g. vapour deposition and then photoetching). Then a second insulating layer 24 of phosphosilicate glass (PSG) having a thickness in the range of from 0.8 to 1.2 microns (e.g. approximately 1.0 micron) is formed on the first conductor layer 23.

It is possible to use silicon dioxide ($SiO_2$), silicon nitride ($Si_3N_4$) or borosilicate glass (BSG) instead of phosphosilicate glass.

A positive type photoresist layer 25 having a thickness in the range of from 1.0 to 2.0 microns (e.g. approximately 1.5 microns) is coated on the second insulating layer 24 and then selectively removed to make a desired opening 26.

It is alternatively possible to use a negative type photoresist instead of a positive type photoresist.

A portion (having a thickness in the range of from 0.5 to 0.8 microns, e.g. approximately 0.7 microns) of the second insulating layer 24 of PSG is selectively etched by an etching solution of acid ammonium fluoride and nitric acid through the opening 26 to form a part or preceding hole 27, as illustrated in Figure 5A. Since the etching solution causes a so-called undercut, the part or preceding hole 27 has a slope.

If a second insulating layer of $SiO_2$, $Si_3N_4$ or BSG is selectively wet-etched, a suitable etching solution for the insulating material (e.g. a mixture of hydrofluoric acid and alcohol) should be used.

Since either nitric acid or alcohol exists in the etching solution used, the etching solution penetrates into the interface between the photoresist layer 25 and the insulating layer 24 to generate a large undercut at the upper portion of the insulating layer.

Next, the photoresist layer 25 is heated up to the softening point thereof so that an end portion 28 of the photoresist layer bends around the part or preceding hole 27. When the above heat-treatment is carried out, the end portion 28 should be kept off the slope of the part or preceding hole 27 (e.g. there should be no contact between the end portion 28 and the slope), as illustrated in Figure 5B. For example, in a case where a positive type photoresist layer 25 of a thickness of 1.5 microns is used, it is possible to heat the photoresist layer at a temperature in the range of 160°C to 180°C (preferably 170°C) for a period in the range from 10 minutes to 40 minutes (preferably 20 minutes). Of course, the heating temperature and the length of time depends on the thickness of layer 25 and the properties of the material used for layer 25.

The exposed portion of the second insulating layer 24 is dry-etched through the window 26, for example by reactive sputter etching or plasma etching, to complete a through hole 29, as illustrated in Figure 5C.

In this case, the dry-etching causes a smaller undercut as compared with wet-etching and the opening of the photoresist layer 25 is shaped into a truncated cone, so that the formed through hole 29 can have a slope. Since the space between the bottom plane of the photoresist layer 25 and the slope of the part or preceding hole 28 (Figure 5B) is small, the top plane size of the part or preceding hole 28 is not enlarged by the dry-etching. For example, after heat treatment, the PSG insulating layer 24, having a part or preceding hole 0.7 microns deep, can be etched by reactive sputter etching in a planar type dry-etching apparatus under the following conditions: a power density of 0.7 watt/cm² of a silicon substrate (e.g. 0.7 watt per square centimetre of silicon substrate), a pressure of 0.266 mbar (0.2 Torr), $CHF_3$ etchant gas, and an etching period of 5 minutes. As a result, the slope of the through hole 29 has an angle in the range of from 18° to 30°. It is possible to use $CF_4$ or $C_2F_6$ as an etchant gas instead of $CHF_3$.

If insulating layer 24 is made of $SiO_2$, $Si_3N_4$ or BSG, one of the above etchant gases $CHF_3$, $CF_4$ and $C_2F_6$ can be used.

Then, the photoresist layer 25 is removed. A second conductor layer 30 made of metal (e.g. aluminium) and having a desired pattern is formed on the second insulating layer 24 by a conventional process. The formed second conductor layer 30 comes into contact with the first conductor layer 23 through the through hole 29, as illustrated in Figure 5D. The slope of the through hole 29 can prevent cracks occurring in the second conductor layer 30.

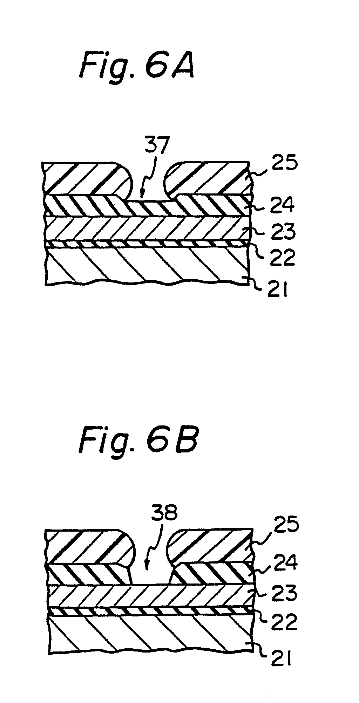

If a part or preceding hole 37 having a depth of 0.3 microns, instead of 0.7 microns as for part or preceding hole 27 in Figure 5A, is formed in a PSG insulating layer 24 by wet-etching and a photoresist layer 25 is heated at 170°C for 20 minutes, the end portion of the photoresist 25 comes into contact with the slope of the part or preceding hole 37, as illustrated in Figure 6A. When this is followed by dry-etching of a portion of the PSG insulating 24 through the opening of the photoresist layer 25 by reactive sputter etching under the same conditions as mentioned above, except than an etching period of 8 minutes is employed, the result is a completed through hole 38 having a steep slope, as illustrated in Figure 6B. After removal of the photoresist layer 25, when a second conductor layer (not shown) is formed on the PSG layer 24 and the exposed portion of the first conductor layer 23, there is a risk of cracks occurring in the second conductor layer at the top of the steep slope of the through hole 38. Also, the period of reactive sputter etching is relatively long and there may be a relatively large change in quality of the photoresist layer due to the dry-etching. The change in quality of the upper portion of the photoresist layer can cause problems in removal of the photoresist layer.

The method of Figures 6A and 6B, employing a relatively shallow part or preceding hole 37 and a relatively long period of reactive sputter etching, may not be as good as the method of Figures 5A to 5D.

When a contact through hole is formed in accordance with a method embodying the present invention, it is possible to prevent cracks from occurring in a conductor layer on an insulating layer and on the slope of the through hole. As a result, reliability of semiconductor devices manufactured by a method embodying the present invention and the yield of good semiconductor devices as a proportion of a total number of semiconductor devices produced can be increased. Furthermore, dimensions of the top plane of a contact through hole formed in accordance with an embodiment of the present invention are not enlarged during the dry etching by a so-called undercut, so that the through hole can be accurately shaped to a predetermined size, whereby density of an integrated circuit can be increased.

It will be apparent that the present invention is not restricted to the embodiments described above.

Embodiments of this invention can provide a process for forming a contact through hole in an insulating layer, for example between multi-layer conductors, in which the through hole has a slope which is essentially a straight line (as seen in cross-section) angled between 18° and 30°.

## Claims

1. A process for forming a contact through hole in an insulating layer disposed on a first conductor layer comprising the steps of forming on the insulating layer a patterned photoresist layer having an opening therein corresponding to the desired through hole; wet-etching part way through the insulating layer, using the photoresist layer as a mask, to form a part or preceding hole that has sloping sides and undercuts the end portion of the photoresist layer; heating the photoresist layer at a temperature under the softening point of the photoresist to bend the end portion of the photoresist layer around the part or preceding hole so that the said end portion does not come into contact with the slope of the part or preceding hole; and dry etching the insulating layer, using the photoresist layer as a mask, to complete the through hole with sloping sides.

2. A process as claimed in claim 1, wherein the insulating layer has a thickness in the range 0.8 to 1.2 microns.

3. A process as claimed in claim 1 or 2, wherein in the step of wet-etching a part of insulating layer having a thickness in the range 0.5 to 0.8 microns is removed by a suitable etching solution to form the part or preceding hole.

4. A process as claimed in claim 3, wherein the said part of the insulating layer has a thickness of approximately 0.7 microns.

5. A process as claimed in any preceding claim, wherein the photoresist layer has a thickness in the range 1.0 to 2.0 microns.

6. A process as claimed in any preceding claim, wherein the photoresist layer is heated at a temperature in the range 160° C to 180° C.

7. A process as claimed in any preceding claim, wherein the dry-etching step is carried out by reactive sputter etching or plasma etching.

8. A process as claimed in any preceding claim, wherein the insulating layer comprises either phosphosilicate glass, silicon dioxide, silicon nitride or borosilicate glass.

9. A process according to any preceding claim that comprises the further steps of removing the photoresist layer and forming a second conductor layer of metal to form a contact with the first conductor layer through said through hole.

10. A process as claimed in any preceding claim, wherein the formation of the through hole is performed for the production of a semiconductor device.

11. A semiconductor device made by a process as claimed in claim 10.

## Patentansprüche

1. Verfahren zur Bildung eines Kontaktdurchgangloches in einer isolierenden Schicht, die auf einer ersten Leiterschicht angeordnet ist, mit den Schritten der Bildung, auf einer isolierenden Schicht, einer gemusterten Fotoresistschicht, die eine Öffnung aufweist, welche dem gewünschten Durchgangsloch entspricht; des teilweisen Feuchtätzens durch die isolierende Schicht, unter Verwendung der Fotoresistschicht als eine Maske, um ein Teil- oder Vorloch zu bilden, das geneigte Seiten hat und den Endabschnittes der Fotoresistschicht unterschneidet; Erhitzen der Fotoresistschicht auf eine Temperatur unter dem Erweichungspunkt des Fotoresist, um den Endabschnitt der Fotoresistschicht um das Teil- oder Vorloch so zu biegen, daß der genannte Endabschnitt nicht mit der Neigung des Teil- oder Vorlochs in Kontakt kommt; und Trockenätzen der isolierenden Schicht, unter Verwendung der Fotoresistschicht als Maske, um das Durchgangsloch mit geneigten Seiten zu vervollständigen.

2. Verfahren nach Anspruch 1, bei welchem die isolierende Schicht eine Dicke im Bereich zwischen 0,8 und 1,2 Mikron hat.

3. Verfahren nach Anspruch 1 oder 2, bei welchem bei dem Schritt des Feuchtätzens ein Teil der isolierenden Schicht, mit einer Dicke im Bereich zwichen 0,5 und 0,8 Mikron, durch eine geeignete Ätzlösung entfernt wird, um das Teil- oder Vorloch zu bilden.

4. Verfahren nach Anspruch 3, bei welchem der genannte Teil der isolierenden Schicht eine Dicke von etwa 0,7 Mikron hat.

5. Verfahren nach einem der vorhergehenden Ansprüche, bei welchem die Fotoresistschicht eine Dicke im Bereich zwischen 1,0 und 2,0 Mikron hat.

6. Verfahren nach einem der vorhergehenden Ansprüche, bei welchem die Fotoresistschicht auf eine Temperatur im Bereich von 160° c bis 180° C aufgeheizt wird.

7. Verfahren nach einem der vorhergehenden Ansprüche, dadurch gekennzeichnet, daß der Schritt des Trockenätzens durch reaktives Zerstäubungsätzen oder durch Plamaätzen durchgeführt wird.

8. Verfahren nach irgendeinem vorhergehenden Anspruch, bei welchem die isolierende Schicht entweder Phosophorsilikatglas, Siliziumdioxid, Siliziumnitrid oder Borsilikatglas umfaßt.

9. Verfahren nach einem der vorhergehenden Ansprüche, welches ferner die Schritte der Entfernung der Fotoresistschicht und Bildung einer zweiten Leiterschicht aus Metall umfaßt, um durch das genannte Durchgangsloch einen Kontakt mit der ersten Leiterschicht zu bilden.

10. Verfahen nach einem der vorhergehenden Ansprüche, bei welchem die Bildung des Durchgangsloches für die Herstellung einer Halbleitervorrichtung durchgeführt wird.

11. Halbleitervorrichtung, hergestellt durch ein Verfahren nach Anspruch 10.

## Revendications

1. Procédé de formation d'un trou passant de contact dans une couche isolante disposée sur une première couche conductrice, comprenant les opérations suivantes: former sur la couche isolante une couche de vernis photosensible configurée possédant une ouverture qui correspond au trou passant voulu; inciser par voie humide partiellement la couche isolante, en utilisant la couche de vernis photosensible comme masque, pour former un trou partiel, ou avant-trou, qui possède des côtés inclinés et entaille par en dessous la partie terminale de la couche de vernis photosensible; chauffer la couche de vernis photosensible à une température inférieure au point de ramollissement du vernis photosensible afin de faire fléchir la partie terminale de la couche de vernis photosensible autour du trou partiel, ou avant-trou, de façon que ladite partie terminale ne vienne pas en contact avec la partie inclinée du trou partiel ou avant-trou; et inciser à sec la couche isolante, en utilisant la couche de vernis photosensible comme masque, afin d'achever la formation du trou passant ayant des côtés inclinés.

2. Procédé selon la revendication 1, où la couche isolante possède une épaisseur comprise entre 0,8 et 1,2 µm.

3. Procédé selon la revendication 1 ou 2, où, dans l'opération d'incision par voie humide, on enlève à l'aide d'une solution d'incision appropriée une partie de couche isolante pour une épaisseur comprise entre 0,5 et 0,8 µm afin de former le trou partiel ou avant-trou.

4. Procédé selon la revendication 3, où ladite partie de la couche isolante possède une épaisseur d'environ 0,7 µm.

5. Procédé selon l'une quelconque des revendications précédentes, où la couche de vernis photosensible a une épaisseur comprise entre 1,0 et 2,0 µm.

6. Procédé selon l'une quelconque des revendications précédentes, où on chauffe la couche de vernis photosensible à une température comprise entre 160°C et 180°C.

7. Procédé selon l'une quelconque des revendications précédentes, où on effectue l'opération d'incision à sec par incision par pulvérisation réactive ou par incision par plasma.

8. Procédé selon l'une quelconque des revendications précédentes, où la couche isolante comprend du verre de phosphosilicate, du dioxyde de silicium, du nitrure de silicium ou bien du verre de borosilicate.

9. Procédé selon l'une quelconque des revendications précédentes, qui comprend les opérations supplémentaires suivantes: enlever la couche de vernis photosensible et former une deuxième couche conductrice de métal afin de former un contact avec la première couche conductrice au travers dudit trou passant.

10. Procédé selon l'une quelconque des revendications précédentes, où on effectue la formation du trou passant en vue de la production d'un dispositif semiconducteur.

11. Dispositif semiconducteur fabriqué par un procédé selon la revendication 10.

*Fig. .1*

6

5
1
2
3
4

*Fig. 2*

7

5
1
2
3
4

Fig. 3A

Fig. 3B

Fig. 4A

Fig. 4B

Fig. 5A

Fig. 5B

Fig. 5C

Fig. 5D

Fig. 6A

Fig. 6B